# EUROPÄISCHE PATENTSCHRIFT

(11) **EP 0 922 304 B1**
(45) Veröffentlichungstag und Bekanntmachung des Hinweises auf die Patenterteilung: **20.02.2002**
(21) Anmeldenummer: 96939013.7
(22) Anmeldetag: 12.11.1996
(51) Int. Cl.: H01L 31/113, G01P 15/12

(54) **SENSORELEMENT**
SENSOR ELEMENT
ELEMENT DE DETECTION

(43) Veröffentlichungstag der Anmeldung: 16.06.1999
(73) Patentinhaber: FRAUNHOFER-GESELLSCHAFT ZUR FÖRDERUNG DER ANGEWANDTEN FORSCHUNG E.V., 80636 München (DE)
(72) Erfinder: ASLAM, Amer, D-47198 Duisburg (DE); HOSTICKA, Bedrich, D-47058 Duisburg (DE); BROCKHERDE, Werner, D-47259 Duisburg (DE); SCHANZ, Michael, D-46147 Oberhausen (DE)
(74) Vertreter: Schoppe, Fritz, Dipl.-Ing.
(86) Internationale Anmeldenummer: EP9604947
(87) Internationale Veröffentlichungsnummer: WO9821756

(56) Entgegenhaltungen:
- DE-A- 4 004 179
- US-A- 4 788 581
- US-A- 5 343 064
- US-A- 5 541 878
- PATENT ABSTRACTS OF JAPAN vol. 095, no. 008, 29.September 1995 & JP 07 115182 A (MATSUSHITA ELECTRIC IND CO LTD), 2.Mai 1995,

## Beschreibung

Die vorliegende Erfindung bezieht sich auf ein monolithisch-integriertes Sensorelement, das einen gegenüber einer zu erfassenden physikalischen Größe empfindlichen Feldeffekttransistor und einen nicht-flüchtigen Speicher aufweist.

Es ist bekannt, ein Sensorelement und einen nicht-flüchtigen Speicher durch zwei getrennte Bauelemente auf einem Chip zu realisieren. Dabei kann beispielsweise ein MOS-Transistor als Sensor wirken, und ein zweiter MOS-Transistor kann als nicht-flüchtiger Speicher wirken. Bekannte derartige nicht-flüchtige Speicher sind EPROMs, Flash-EPROMs, EEPROMs, usw.. EEPROMs werden aufgrund ihrer einfachen Programmierung häufig als nicht-flüchtige digitale Speicher verwendet. Eine analoge Speicherung von Informationen in einer einzelnen EEPROM-Zelle kann die Speicherdichte erhöhen und die Schaltungstechniken für die analoge Signalverarbeitung vereinfachen, wenn eine Langzeitspeicherung notwendig ist.

Da bei den genannten Sensorelementen gemäß dem Stand der Technik der eigentliche Sensor und der nicht-flüchtige Speicher durch zwei Transistoren realisiert sind, wird eine große Chipfläche zur Realisierung eines Sensorelements benötigt. Ferner treten durch herstellungsbedingte örtliche Parameterschwankungen Anpassungsprobleme zwischen den beiden Transistoren, die ein Sensorelement bilden, auf, wodurch das Ausgangssignal verändert wird. Desweiteren ist eine Signalverarbeitungseinheit notwendig, die das Sensorsignal und den Speicherinhalt verarbeitet.

Die US-A-4,788,581 betrifft ein MOS-Dosimeter, um eine Dosis innerhalb eines Strahlungsfeldes zu messen. Das Dosimeter umfaßt ein Halbleitersubstrat, eine Isolationsschicht auf dem Halbleitersubstrat, welche gegenüber der Strahlung beständig ist, und welche mit einem Floating-Gate versehen ist. Ferner ist ein Metallkontakt mit einem Halbleitersubstrat verbunden. Das Floating-Gate wird verwendet, um eine Ladung anzusammeln, wobei die angesammelte Ladung der Dosierung der Strahlung entspricht. Die Ansammlung der Ladung kann zur erneuten Verwendung des Dosimeters zurückgesetzt werden.

Die JP-A-07115182 betrifft einen photoelektrischen Wandler mit einer Speicherfunktion, bei dem in einem Siliziumsubstrat eine Schicht vorgesehen ist, in der eine Source- und eine Drain-Schicht eindiffundiert sind. Ein Floating-Gate ist auf einem Tunnel-Oxidfilm angeordnet und ferner ist ein Steuerungs-Gate, welches aus polychristallinem Silizium besteht, auf dem Floating-Gate abgeschieden, wobei zwischen diesen beiden Gates ein Oxidfilm angeordnet ist. Ein photoelektrischer Wandler ist durch die Photoleitschicht und eine durchsichtige Elektrode gebildet.

Die Aufgabe der vorliegenden Erfindung besteht darin, ein platzsparendes Sensorelement mit zugehörigem nicht-flüchtigem Speicher zu schaffen, bei dem ferner keine durch herstellungsbedingte örtliche Parameterschwankungen verursachte Anpassungsprobleme zwischen Sensor- und Speicher-Zelle existieren.

Diese Aufgabe wird durch eine Sensorvorrichtung gemäß Anspruch 1 gelöst.

Die vorliegende Erfindung schafft ein Sensorelement in der Form eines gegenüber einer zu erfassenden physikalischen Größe empfindlichen Feldeffekttransistors, dessen Gate-Elektrode als Floating-Gate ausgebildet ist. Indem die Gate-Elektrode des Transistors als Floating-Gate ausgebildet ist, kann dieselbe sowohl zur Arbeitspunkteinstellung des Transistors als auch zur Speicherung einer Ladung, die einer durch den Feldeffekttransistor erfaßten physikalischen Größe entspricht, verwendet werden. Dazu ist der Feldeffekttransistor mit einem Komparator und einer Programmiereinheit für den EEPROM, der durch das Floating-Gate gebildet ist, verschaltet.

Der durch das Floating-Gate des erfindungsgemäßen Sensorelements gebildete nicht-flüchtige Speicher kann zur Einstellung des Arbeitspunktes des gegenüber einer zu erfassenden physikalischen Größe empfindlichen Feldeffekttransistors, zur Abspeicherung von Koeffizienten für die weitere Signalverarbeitung oder zur Abspeicherung des erfaßten Signals selbst verwendet werden. Bei einem bevorzugten Ausführungsbeispiel der vorliegenden Erfindung ist der gegenüber einer zu erfassenden physikalischen Größe empfindliche Feldeffekttransistor ein photoempfindlicher Transistor, der einen optischen Sensor mit einem integrierten, programmierbaren nicht-flüchtigen EEPROM-Speicher darstellt. Das erfindungsgemäße Sensorelement kann in einer Standard-Single-Poly-CMOS/EEPROM-Technologie realisiert sein. Ferner kann das erfindungsgemäße Sensorelement ebenso in der Double-Poly-CMOS/EEPROM-Technologie realisiert werden, wodurch der Platzbedarf des Bauelements weiter verringert werden kann.

Neben der CMOS-Technologie kann das erfindungsgemäße Sensorelement unter Verwendung weiterer Technologien realisiert werden, solange der Sensor an einem Gate-Anschluß in seinem Arbeitspunkt verstellt werden kann. Beispielsweise kann der gegenüber einer zu erfassenden physikalischen Größe empfindliche Feldeffekttransistor des erfindungsgemäßen Sensorelements ein CMOS-Drucksensor oder -Beschleunigungssensor sein, dessen Gate-Elektrode örtlich verschiebbar ist. Wird der Transistor mit einem Druck oder einer Beschleunigung beaufschlagt, kann der Druck oder die Beschleunigung durch die örtliche Verschiebung der Gate-Elektrode registriert werden. Wird bei dem Drucksensor oder dem Beschleunigungssensor die Gate-Elektrode als Floating-Gate ausgeführt, läßt sich ein nicht-flüchtiger Speicher in dem Sensor integrieren.

Durch die vorliegende Erfindung wird die Trennung des Sensors und des Speicherbausteins aufgehoben. Der Sensor enthält ein Floating-Gate, das Ladungen nicht-flüchtig speichern kann. Die auf dem Floating-Gate gespeicherten Ladungen beeinflussen den Arbeitspunkt des Sensors. Somit kann dieser als analoger oder digitaler Wert nicht-flüchtig gespeichert werden. Folglich erhält man mit der vorliegenden Erfindung ein Sensorelement, das einen analogen nicht-flüchtigen Speicher in dem Sensor selbst beinhaltet, welcher zur Arbeitspunkteinstellung, beispielsweise zur Offset-Korrektur, oder auch zur Signalverarbeitung benutzt werden kann.

Die Realisierung des Sensors und des Speichers in einem einzelnen Bauelement erspart sehr viel Chipfläche gegenüber der getrennten Realisierung gemäß dem Stand der Technik, da praktisch zwei Bauelemente in einem zusammengefaßt sind. Zusätzliche Fertigungskosten fallen nicht an, da derselbe Herstellungsprozeß verwendet werden kann. Ferner werden durch herstellungsbedingte örtliche Parameterschwankungen verursachte Abweichungen zwischen Sensor- und Speicherzelle eliminiert, da die Sensor- und die Speicherzelle in einem Bauelement integriert sind. Ferner ist keine Verarbeitungseinheit notwendig, die das Sensorsignal mit dem gespeicherten Wert verarbeitet. Die Verarbeitung kann in dem erfindungsgemäßen Sensorelement selbst geschehen. Die Verarbeitung kann beispielsweise durch die Ausnutzung der Transistorkennlinien in den unterschiedlichen Arbeitsbereichen des Transistors durchgeführt werden.

Der nicht-flüchtige Speicher des Sensors kann ferner dazu verwendet werden, um das aufgenommene Sensorsignal zu speichern. Dazu wird mit Hilfe einer Regelschleife so viel Ladung auf das Floating-Gate transportiert, daß das Ausgangssignal des Sensors einen definierten Wert erreicht. Das Sensorsignal ist dann als eine Ladungsänderung, die auf dem Floating-Gate vorliegt, in dem Sensor gespeichert.

Bevorzugte Ausführungsbeispiele der vorliegenden Erfindung werden nachfolgend bezugnehmend auf die beiliegenden Zeichnungen näher erläutert. Es zeigen:
- Fig. 1: schematisch den Aufbau eines bevorzugten Ausführungsbeispiels eines erfindungsgemäßen Sensorelements;
- Fig. 2: eine Darstellung der optischen Kennlinien des in Fig. 1 dargestellten Sensorelements bei verschiedenen vorprogrammierten Schwellenspannungen; und
- Fig. 3: eine schematische Darstellung einer Regelschleife zur Abspeicherung des Sensorsignals auf dem Sensorspeicher.

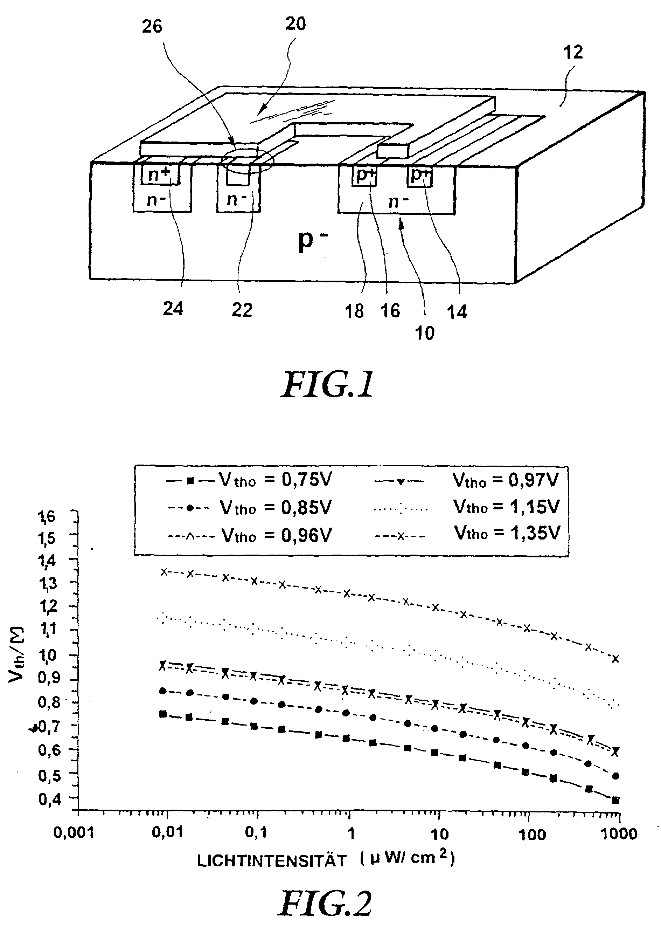

Anhand von Fig. 1, die ein bevorzugtes Ausführungsbeispiel der vorliegenden Erfindung in der Form eines photoempfindlichen Sensorelements darstellt, wird nachfolgend die vorliegende Erfindung näher erläutert.

Ein Photo-Feldeffekttransistor 10 ist in einem Substrat 12 gebildet. Der Photo-Feldeffekttransistor ist ein p-Kanal-MOS-Transistor, dessen p⁺-dotierte Source 14 und dessen p⁺-dotiertes Drain 16 in einer floatenden n-Wanne 18 liegen.

Über dem p-Kanal des Transistors liegt anstelle des üblichen Gates ein Floating-Gate 20, das Ladungen nicht-flüchtig speichern kann. Das Floating-Gate 20 ist derart ausgebildet, daß ein Abschnitt desselben über n-dotierten Bereichen in dem p-Substrat 12 angeordnet ist. Ein erster n-dotierter Bereich 22 dient als Injektionsbereich, während ein zweiter n-dotierter Bereich 24 als Steuerbereich dient. Das Floating-Gate 20 und der Injektionsbereich 22 sind einander gegenüberliegend derart angeordnet, daß zwischen denselben eine Tunnelregion 26 gebildet ist.

Treffen nun Lichtwellen auf das Sensorelement auf, bewirkt der Photoeffekt, daß sich Elektronen in der n-Wanne des Transistors 10 ansammeln, wodurch die Schwellenspannung des PMOS-Transistors verschoben wird. Die Schwellenspannung Vₜₕ zeigt eine nahezu logarithmische Abhängigkeit von der einfallenden Lichtintensität. Die Schwellenspannung Vₜₕ ist ferner von eventuell auf dem Floating-Gate vorliegenden Ladungen abhängig. Die Schwellenspannung Vₜₕ kann beispielsweise als die Gate-Spannung definiert werden, die einen Drainstrom von 10 µA bei einer Drain-Source-Spannung von 2 Volt bewirkt.

Dadurch, daß die Schwellenspannung durch auf dem Floating-Gate befindliche Ladungen verschoben werden kann, ist eine einfache nicht-flüchtige Offset-Korrektur oder Arbeitspunkteinstellung des photoempfindlichen Sensors möglich.

In Fig. 2 sind optische Kennlinien des in Fig. 1 dargestellten Sensorelements bei verschiedenen vorprogrammierten Schwellenspannungen des Sensor-Transistors dargestellt. Diese Schwellenspannungen können programmiert werden, indem Elektronen durch das Anlegen einer Hochspannung zwischen dem Steuerbereich 24 und dem Injektionsbereich 22 zu dem Floating-Gate 20 bewegt oder von demselben entfernt werden. Dies geschieht durch einen Tunneleffekt zwischen dem Injektionsbereich 22 und dem über demselben angeordneten Abschnitt des Floating-Gates 20.

In Fig. 2 sind die optischen Kennlinien des Sensors logarithmisch für Spannungen Vₜₕₒ betragsmäßig von 0,75 Volt bis 1,35 Volt dargestellt, wobei Vₜₕₒ die Schwellenspannung Vₜₕₒ ohne Lichteinstrahlung darstellt. Wie in Fig. 2 zu erkennen ist, verändern die programmierten Schwellenspannungen die logarithmische Abhängigkeit der Kennlinie des Sensors von der einfallenden Lichtintensität nicht.

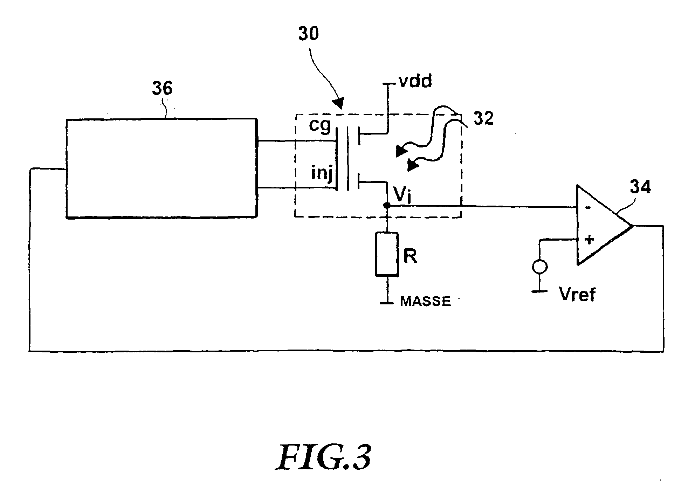

In Fig. 3 ist eine Regelschleife dargestellt, die es auf eine einfache Art und Weise ermöglicht, eine einem optischen Signal entsprechende Ladung auf dem Floating-Gate zu speichern. In der gestrichelten Markierung 30 ist das Schaltzeichen des Photo-Feldeffekttransistors mit integriertem EEPROM-Speicher, der das Sensorelement gemäß dem bevorzugten Ausführungsbeispiel der Erfindung darstellt, gezeigt. Dieses Sensorelement wird mit einer Lichtbestrahlung 32 beaufschlagt. An der Source-Elektrode des Transistors liegt eine Versorgungsspannung vdd. Die Drain-Elektrode des Transistors ist über einen Widerstand R mit Masse verbunden. Die Drain-Elektrode ist ferner mit einem ersten Eingang eines Komparators 34 verbunden. Der zweite Eingang des Komparators ist mit einer Spannungsquelle verbunden, die eine Referenzspannung V_{ref} an denselben anlegt. Der Ausgang des Komparators ist mit einer Programmiereinheit 36 für den EEPROM des Photo-Feldeffekttransistors. Die Programmiereinheit 36 ist mit dem Steuerbereich 24 und dem Injektionsbereich 22 verbunden.

Die Referenzspannung V_{ref} entspricht der Ausgangsspannung Vᵢ, wenn keine Lichteinstrahlung 32 vorliegt. Wird der Transistor mit einer Lichteinstrahlung 32 beaufschlagt, verschiebt sich die Schwellenspannung des Transistors, was eine Änderung der Ausgangsspannung Vᵢ zur Folge hat. Dies wird durch den Komparator 34 erfaßt, woraufhin durch die Programmiereinheit 36 solange Ladungen auf das Floating-Gate aufgebracht werden, bis die Ausgangsspannung Vᵢ die Referenzspannung V_{ref} erreicht. Ist dies der Fall, ist die durch die Lichteinstrahlung 32 veränderte Schwellenspannung des PMOS-Transistors durch die Ladungen auf dem Floating-Gate, die eine Schwellenspannungsverschiebung bewirken, kompensiert. Somit ist eine der Lichtleistung entsprechende Spannung als Schwellenspannungsänderung auf dem Floating-Gate in dem Sensor gespeichert.

Die vorliegende Erfindung liefert somit ein monolithisch-integriertes Sensorelement, bei dem herstellungsbedingte Parameterschwankungen oder auch Anpassungen an veränderte Umweltbedingungen durch einen in dem Sensorelement integrierten nicht-flüchtigen Speicher kompensiert werden können. Die Kompensationsinformationen werden dabei auf das Floating-Gate gespeichert. Ferner eignen sich die erfindungsgemäßen Speicher gut als Analogspeicher, da dieselben das analoge Signal des Sensors direkt verarbeiten können oder eine zu programmierende analoge Arbeitspunktspannung dauerhaft speichern können. Das erfindungsgemäße Bauelement enthält gleichzeitig ein Sensorelement und einen nicht-flüchtigen Speicher.

Das Sensorelement gemäß der vorliegenden Erfindung kann in zahlreichen Anwendungen, beispielsweise auf dem Gebiet von neuronalen Netzwerken mit nicht-flüchtigen Massenspeichern oder auf dem Gebiet von Lernkameras, die Bildmuster nur durch ein "Betrachten" lernen können, verwendet werden. Die nicht-flüchtige Speicherungsmöglichkeit ermöglicht ferner eine Versatz- und Empfindlichkeits-Korrektur des Sensors, so daß ein festes Musterrauschen in großen Photosensorarrays beseitigt werden kann.

## Patentansprüche

1. Sensorvorrichtung, mit
einem Sensorelement (30) in der Form eines gegenüber einer zu erfassenden physikalischen Größe empfindlichen Feldeffekttransistors (10), dessen Gate-Elektrode (20) als Floating-Gate ausgebildet ist;
**dadurch gekennzeichnet,**
**daß** eine Änderung der Schwellenspannung (Vₜₕₒ) des Feldeffekttransistors (10) in Äbhängigkeit von der erfaßten physikalischen Größe mittels einer Programmiereinheit (36) durch Zufuhr oder Entfernung von Ladungen auf das Floating-Gate kompensiert wird, wodurch die der physikalischen Größe entsprechende Schwellenspannungsänderung in Form dieser Ladungen auf dem Floating-Gate gespeichert wird.

2. Sensorvorrichtung gemäß Anspruch 1, **dadurch gekennzeichnet, daß** der Feldeffekttransistor (10) ein photoempfindlicher Feldeffekttransistor ist.

3. Sensorvorrichtung gemäß Anspruch 1 oder 2, **dadurch gekennzeichnet, daß** der Feldeffekttransistor ein Druck- oder Beschleunigungs-empfindlicher Sensor mit einem örtlich verschiebbaren Floating-Gate ist.

4. Sensorvorrichtung gemäß einem der Ansprüche 1 bis 3, **dadurch gekennzeichnet, daß** das Floating-Gate (20) über einen Tunneleffekt mit Ladungen beaufschlagbar ist.

5. Sensorvorrichtung gemäß Anspruch 4, **dadurch gekennzeichnet, daß** der Feldeffekttransistor (10) in einem Substrat (12) ausgebildet ist, und daß das Floating-Gate (20) derart ausgebildet ist, daß ein Abschnitt des Floating-Gates einem in dem Substrat (12) angeordneten hochdotierten Bereich (22) gegenüberliegt, derart, daß zwischen dem hochdotierten Bereich (22) und dem Abschnitt des Floating-Gate (20) eine Tunnelregion gebildet ist.

6. Sensorvorrichtung gemäß Anspruch 1, **dadurch gekennzeichnet, daß** die Source-Elektrode (16) des Feldeffekttransistors (10) mit einer Spannungsquelle (vdd) verbunden ist und die Drain-Elektrode (14) des Feldeffekttransistors (10) über einen Widerstand (R) mit Masse und ferner direkt mit einem ersten Eingang eines Komparators (34) verbunden ist, wobei ein zweiter Eingang des Komparators (34) mit einer Referenzspannungsquelle (V_{ref}) und der Ausgang des Komparators (34) mit der Programmiereinheit (36) verbunden ist.

7. Verfahren zum Speichern einer einer zu erfassenden physikalischen Größe entsprechenden Ladung auf der Sensorvorrichtung gemäß Anspruch 6, **gekennzeichnet durch** folgende Schritte:
Beaufschlagen des Sensorelements mit der zu erfassenden physikalischen Größe (32); und
Aufbringen von Ladungen auf das Floating-Gate (20) mittels der Programmiereinheit (36), bis die am ersten Eingang des Komparators (34) anliegende Spannung (Vᵢ) der am zweiten Eingang des Komparators anliegenden Referenzspannung (V_{ref}) entspricht.

## Claims

1. Sensor device, comprising:
a sensor element (30) in the form of a field effect transistor (10) sensitive to a physical quantity to be detected, the gate electrode (20) of said field effect transistor (10) being implemented as a floating gate;
**characterized in that**
a change of the threshold voltage (Vₜₕₒ) of the field effect transistor (10) in dependence upon the physical quantity detected is compensated by means of a programming unit (36) by means of which charges are applied to and removed from said floating gate, whereby a threshold voltage change corresponding to the physical quantity is stored on the floating gate in the form of these charges.

2. Sensor device according to claim 1, **characterized in that** the field effect transistor (10) is a photosensitive field effect transistor.

3. Sensor device according to claim 1 or 2, **characterized in that** the field effect transistor is a sensor which is sensitive to pressure or acceleration and which has a locally displaceable floating gate.

4. Sensor device according to one of claims 1 to 3, **characterized in that** the floating gate (20) is adapted to be acted upon by charges through a tunnel effect.

5. Sensor device according to claim 4, **characterized in that** the field effect transistor (10) is formed in a substrate (12), and that the floating gate (20) is implemented such that one section of the floating gate is located opposite a heavily doped region (22) arranged in said substrate (12), in such a way that a tunnel region is formed between said heavily doped region (22) and said section of the floating gate (20).

6. Sensor device according to claim 1, **characterized in that** the source electrode (16) of the field effect transistor (10) is connected to a voltage source (vdd) and that the drain electrode (14) of the field effect transistor (10) is connected via a resistor (R) to ground and, in addition, directly to a first input of a comparator (34), a second input of said comparator (34) being connected to a reference voltage source (V_{ref}) and the output of said comparator (34) being connected to the programming unit (36).

7. Method of storing on the sensor device according to claim 7 a charge corresponding to a physical quantity to be detected, **characterized by** the following steps:
applying the physical quantity (32) to be detected to the sensor element; and
applying charges to the floating gate (20) by means of the programming unit (36) until the voltage (Vᵢ) applied to the first input of the comparator (34) corresponds to the reference voltage (V_{ref}) applied to the second input of the comparator.

## Revendications

1. Dispositif de détection, avec
un élément de détection (30) sous forme de transistor à effet de champ (10) sensible à une grandeur physique à détecter dont l'électrode d'enclenchement (20) est réalisée sous forme de grille flottante ;
**caractérisé par le fait qu'**une variation de la tension de seuil (Vₜₕₒ) du transistor à effet de champ (10) est compensée en fonction de la grandeur physique détectée à l'aide d'une unité de programmation (36), par alimentation ou évacuation de charges vers ou de la grille flottante, d'où la variation de tension de seuil correspondant à la grandeur physique est accumulée sous forme de ces charges sur la grille flottante.

2. Dispositif de détection selon la revendication 1, **caractérisé par le fait que** le transistor à effet de champ (10) est un transistor à effet de champ photosensible.

3. Dispositif de détection selon la revendication 1 ou 2, **caractérisé par le fait que** le transistor à effet de champ est un capteur sensible à la pression ou à l'accélération avec une grille flottante déplaçable localement.

4. Dispositif de détection selon l'une des revendications 1 à 3, **caractérisé par le fait que** la grille flottante (20) peut être soumise à des charges par un effet de tunnel.

5. Dispositif de détection selon la revendication 4, **caractérisé par le fait que** le transistor à effet de champ (10) est réalisé dans un substrat (12) et que la grille flottante (20) est réalisée de telle sorte qu'un segment de la grille flottante se trouve face à une zone hautement dopée (22) disposée dans le substrat (12), de sorte qu'il est formé, entre la zone hautement dopée (22) et le segment de la grille flottante (20), une zone de tunnel.

6. Dispositif de détection selon la revendication 1, **caractérisé par le fait que** l'électrode de source (16) du transistor à effet de champ (10) est reliée à une source de tension (vdd) et que l'électrode de drain (14) du transistor à effet de champ (10) est reliée, par l'intermédiaire d'une résistance (R) à la masse et, par ailleurs, directement à une première entrée d'un comparateur (34), une seconde entrée du comparateur (34) étant reliée à une source de tension de référence (V_{ref}) et la sortie du comparateur (34) étant reliée à l'unité de programmation (36).

7. Procédé pour accumuler une charge correspondant à une grandeur physique à détecter sur le dispositif de détection selon la revendication 6, **caractérisé par** l'étape suivante consistant à :
soumettre l'élément de détection à la grandeur physique à détecter (32) ; et
appliquer des charges sur la grille flottante (20) à l'aide de l'unité de programmation (36), jusqu'à ce que la tension (Vᵢ) présente à la première entrée du comparateur (34) corresponde à la tension de référence (V_{ref}) présente à la seconde entrée du comparateur.
